(19) **Europäisches Patentamt / European Patent Office / Office européen des brevets**

(11) **EP 4 779 858 A1**

(12) **EUROPEAN PATENT APPLICATION**
published in accordance with Art. 153(4) EPC

(43) Date of publication:
**22.07.2026  Bulletin 2026/30**

(21) Application number: **24855068.3**

(22) Date of filing: **12.12.2024**

(51) International Patent Classification (IPC):
**H02M 7/219** (2006.01)     **H02M 3/335** (2006.01)
**H02M 1/00** (2006.01)       **H02M 7/48** (2007.01)
**H02M 1/42** (2007.01)       **H02M 3/00** (2006.01)

(52) Cooperative Patent Classification (CPC):
**H02M 1/4258; H02M 1/0009; H02M 1/0058;
H02M 1/4208; H02M 3/01; H02M 3/33573;
H02M 3/33584; H02M 7/219; H02M 7/4807;
H02M 7/4815; Y02B 70/10**

(86) International application number:
**PCT/CN2024/138673**

(87) International publication number:
**WO 2026/085990 (30.04.2026 Gazette 2026/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **22.10.2024  CN 202411475163**

(71) Applicant: **Shinry Technologies Co., Ltd.
Shenzhen, Guangdong 518055 (CN)**

(72) Inventors:
 • **JIA, Minli
   Shenzhen, Guangdong 518055 (CN)**

 • **SUN, Hao
   Shenzhen, Guangdong 518055 (CN)**
 • **ZHANG, Lei
   Shenzhen, Guangdong 518055 (CN)**
 • **HAN, Meng
   Shenzhen, Guangdong 518055 (CN)**
 • **WU, Renhua
   Shenzhen, Guangdong 518055 (CN)**

(74) Representative: **Mathys & Squire
32 London Bridge Street
The Shard
London SE1 9SG (GB)**

(54) **ENERGY CONVERSION APPARATUS, AND VEHICLE**

(57)    An energy conversion device and a vehicle are provided in embodiments of the disclosure. The energy conversion device includes a primary bridge arm module, a filter module, a resonance module, a secondary bridge arm module, and a control module. The primary bridge arm module includes a first bridge arm, a second bridge arm, and a third bridge arm, and the secondary bridge arm module includes a fourth bridge arm and a fifth bridge arm. A frequency of a drive signal for the second bridge arm, a frequency of a drive signal for the third bridge arm, a frequency of a drive signal for the fourth bridge arm, and a frequency of a drive signal for the fifth bridge arm each are higher than a frequency of a drive signal for the first bridge arm. The control module is configured to determine a phase shift angle of a target bridge arm relative to a reference bridge arm according to a demand gain of the energy conversion device, a first sampled current, a second sampled current, a first sampled voltage, and a second sampled voltage, to enable soft switching of switches in the primary bridge arm module and the secondary bridge arm module and energy control. Embodiments of the disclosure can reduce size and cost of the energy conversion device.

EP 4 779 858 A1

FIG. 1

**Description**

CROSS-REFERENCE TO RELATED APPLICATION(S)

This application claims priority to Chinese Patent Application No. 202411475163.5, filed October 22, 2024, and entitled "ENERGY CONVERSION DEVICE AND VEHICLE", which is incorporated herein by reference as if reproduced in its entirety.

TECHNICAL FIELD

This application relates to the field of electronic circuit technology, and particularly to an energy conversion device and a vehicle.

BACKGROUND

With development of electric vehicles, an on-board charger, serving as an energy conversion device for the electric vehicle, has garnered increasing attention. The energy conversion device can convert an alternating current (AC) into a direct current (DC) to charge a high-voltage battery in the electric vehicle. The energy conversion device generally employs a two-stage architecture including a power factor correction (PFC) module and a bidirectional direct current/direct current (DC/DC) module. Decoupling between the PFC module and the DC/DC module is realized through an electrolytic capacitor, which however increases the size and cost of the energy conversion device, resulting in a relatively low power density.

SUMMARY

Embodiments of the disclosure provide an energy conversion device and a vehicle, which can reduce a size and cost of the energy conversion device.

A first aspect of embodiments of the disclosure provides an energy conversion device. The energy conversion device includes a filter module, a primary bridge arm module, a resonance module, a secondary bridge arm module, and a control module. The primary bridge arm module includes a first bridge arm, a second bridge arm, and a third bridge arm, and the secondary bridge arm module includes a fourth bridge arm and a fifth bridge arm. A frequency of a drive signal for the second bridge arm, a frequency of a drive signal for the third bridge arm, a frequency of a drive signal for the fourth bridge arm, and a frequency of a drive signal for the fifth bridge arm each are higher than a frequency of a drive signal for the first bridge arm. A first end of the filter module is connected with a first alternating current (AC) end, a second end of the filter module is connected with a bridge arm midpoint of the third bridge arm and a first end of the resonance module, a third end of the filter module is connected with a bridge arm midpoint of the second bridge arm and a second end of the resonance module, and a bridge arm midpoint of the first bridge arm is connected with a second AC end. A third end of the resonance module is connected with a bridge arm midpoint of the fourth bridge arm, and a fourth end of the resonance module is connected with a bridge arm midpoint of the fifth bridge arm. A first end of the first bridge arm is connected with a first end of the second bridge arm and a first end of the third bridge arm, a second end of the first bridge arm is connected with a second end of the second bridge arm and a second end of the third bridge arm, a first end of the fourth bridge arm is connected with a first end of the fifth bridge arm and a first direct current (DC) end, and a second end of the fourth bridge arm is connected with a second end of the fifth bridge arm and a second DC end. The control module is configured to determine a phase shift angle of a target bridge arm relative to a reference bridge arm according to a demand gain of the energy conversion device, a first sampled current, a second sampled current, a first sampled voltage, and a second sampled voltage, to enable soft switching of switches in the primary bridge arm module and the secondary bridge arm module. The reference bridge arm is one of the second bridge arm, the third bridge arm, the fourth bridge arm, and the fifth bridge arm, and the target bridge arm is a bridge arm other than the reference bridge arm among the second bridge arm, the third bridge arm, the fourth bridge arm, and the fifth bridge arm. The phase shift angle of the target bridge arm relative to the reference bridge arm is used for controlling a timing of a drive signal for the target bridge arm, the first sampled current is a sampled current at the first end of the filter module, the second sampled current is a sampled current between the second end of the fifth bridge arm and the second DC end, the first sampled voltage is a sampled voltage between the first AC end and the second AC end or a sampled voltage between the first end of the third bridge arm and the second end of the third bridge arm, and the second sampled voltage is a sampled voltage between the first DC end and the second DC end.

Optionally, the resonance module includes a resonance inductor, a first resonance capacitor, a second resonance capacitor, and a transformer. The resonance inductor and the first resonance capacitor each are connected in series with a primary winding of the transformer, and the second resonance capacitor is connected in series with a secondary winding of the transformer.

Optionally, the filter module includes a first inductor and a second inductor. A first end of the first inductor is connected with the first end of the second inductor and the first AC end, a second end of the first inductor is connected with the bridge arm midpoint of the third bridge arm, and a second end of the second inductor is connected with the bridge arm midpoint of the second bridge arm.

Optionally, the filter module includes a coupled inductor. A first end of the coupled inductor is connected with a second end of the coupled inductor and the first AC end, a third end of the coupled inductor is connected with the bridge arm midpoint of the third bridge arm, and a fourth end of the coupled inductor is connected with the bridge arm midpoint of the second bridge arm.

Optionally, the energy conversion device further includes a first filter capacitor, a second filter capacitor, and a third filter capacitor. Two ends of the first filter capacitor are respectively connected with the first AC end and the second AC end, two ends of the second filter capacitor are respectively connected with the first end of the third bridge arm and the second end of the third bridge arm, and two ends of the third filter capacitor are respectively connected with the first end of the fifth bridge arm and the second end of the fifth bridge arm.

Optionally, the control module configured to determine the phase shift angle of the target bridge arm relative to the reference bridge arm according to the demand gain of the energy conversion device, the first sampled current, the second sampled current, the first sampled voltage, and the second sampled voltage is configured to: determine a phase shift angle between a first voltage waveform and a second voltage waveform according to the first sampled current, the second sampled current, the first sampled voltage, and the second sampled voltage, where the first voltage waveform is a waveform of a voltage between the bridge arm midpoint of the third bridge arm and the bridge arm midpoint of the second bridge arm, and the second voltage waveform is a waveform of a voltage between the bridge arm midpoint of the fourth bridge arm and the bridge arm midpoint of the fifth bridge arm; and determine the phase shift angle of the target bridge arm relative to the reference bridge arm according to the phase shift angle between the first voltage waveform and the second voltage waveform, the demand gain of the energy conversion device, a turns ratio of the transformer, the first sampled voltage, and the second sampled voltage.

Optionally, the control module includes a phase-locked loop, a first current control loop, a second current control loop, a voltage control loop, a multiplier, a minimum selection module, and a phase-shift modulation module. The phase-locked loop is configured to output a first loop calculation result by performing loop calculation on the first sampled voltage. The second current control loop is configured to output a second loop calculation result by performing loop calculation on a result of a subtraction operation between the second sampled current and a first reference current. The voltage control loop is configured to output a third loop calculation result by performing loop calculation on a result of a subtraction operation between the second sampled voltage and a second reference voltage. The minimum selection module is configured to select a minimum value from the second loop calculation result and the third loop calculation result. The multiplier is configured to obtain a second reference current by multiplying the first loop calculation result with the minimum value selected from the second loop calculation result and the third loop calculation result. The first current control loop is configured to output the phase shift angle between the first voltage waveform and the second voltage waveform by performing loop calculation on a result of a subtraction operation between the first sampled current and the second reference current. The phase-shift modulation module is configured to determine the phase shift angle of the target bridge arm relative to the reference bridge arm according to the phase shift angle between the first voltage waveform and the second voltage waveform, the demand gain of the energy conversion device, the turns ratio of the transformer, the first sampled voltage, and the second sampled voltage.

Optionally, in response to the reference bridge arm being the third bridge arm and the target bridge arm including the second bridge arm, the fourth bridge arm, and the fifth bridge arm, when the demand gain of the energy conversion device is less than 1, a phase shift angle of the second bridge arm relative to the third bridge arm, a phase shift angle of the fourth bridge arm relative to the third bridge arm, and a phase shift angle of the fifth bridge arm relative to the third bridge arm are determined according to the following formulas:

$$D_p=(1-D_{y1}); \ D_{s1}=(1-D_{y1}-D_{\alpha 1}); \ D_{s2}=(1-D_{y1}-D_{\alpha 1});$$

$$D_{\alpha 1}=(1-D_{y1}+2D_\Phi)/2;$$

$$\text{if } D_\Phi < D_{\Phi B}, D_{y1}=k\times(2D_\Phi+1)/(2-k); \text{ if } D_\Phi \geq D_{\Phi B}, D_{y1}=[2\times D_\Phi\times(1-k)+2k-1]/k;$$

$$D_{\Phi B}=(1-k)/2, \ k=G_e;$$

where $G_e$ represents the demand gain of the energy conversion device, $D_\Phi$ represents the phase shift angle between the first voltage waveform and the second voltage waveform, $D_p$ represents the phase shift angle of the second bridge arm relative to the third bridge arm, $D_{s1}$ represents the phase shift angle of the fourth bridge arm relative to the third bridge arm, and $D_{s2}$ represents the phase shift angle of the fifth bridge arm relative to the third bridge arm.

Optionally, when the demand gain of the energy conversion device is greater than or equal to 1:

$$D_p=0; \; D_{s1}=D_{\alpha2}-(1-D_{y2}); \; D_{s2}= D_{\alpha2};$$

$$D_{\alpha2}=(1-D_{y2}+2D_\Phi)/2;$$

$$\text{if } D_\Phi < D_{\Phi B}, \; D_{y2}=k\times(2D_\Phi+1)/(2-k); \; \text{if } D_\Phi \geq D_{\Phi B}, \; D_{y2}=[2\times D_\Phi \times (1-k)+2k-1]/k;$$

$$D_{\Phi B}=(1-k)/2, \; k=1/G_e;$$

where $G_e$ represents the demand gain of the energy conversion device, $D_\Phi$ represents the phase shift angle between the first voltage waveform and the second voltage waveform, $D_p$ represents the phase shift angle of the second bridge arm relative to the third bridge arm, $D_{s1}$ represents the phase shift angle of the fourth bridge arm relative to the third bridge arm, and $D_{s2}$ represents the phase shift angle of the fifth bridge arm relative to the third bridge arm.

A second aspect of embodiments of the disclosure provides a vehicle. The vehicle includes the energy conversion device in the first aspect of the embodiments of the disclosure and a battery. The energy conversion device is configured to convert an AC into a DC to charge the battery.

The energy conversion device of embodiments of the disclosure has less bridge arms compared to a two-stage architecture including a power factor correction (PFC) module and a direct current/direct current (DC/DC) module, which can reduce the size and cost of the energy conversion device. The control module of the energy conversion device can determine the phase shift angle of the target bridge arm relative to the reference bridge arm according to the demand gain of the energy conversion device, the first sampled current, the second sampled current, the first sampled voltage, and the second sampled voltage, to enable soft switching of switches in the primary bridge arm module and the secondary bridge arm module, which can reduce switching loss, thereby improving a conversion efficiency of the energy conversion device.

## BRIEF DESCRIPTION OF THE DRAWINGS

In order to describe technical solutions of embodiments of the disclosure or the related art more clearly, the following will give a brief description of accompanying drawings used for describing the embodiments or the related art. Apparently, accompanying drawings described below are merely some embodiments. Those of ordinary skill in the art can also obtain other accompanying drawings based on the accompanying drawings described below without creative efforts.

FIG. 1 is a schematic structural diagram illustrating an energy conversion device provided in embodiments of the disclosure.

FIG. 2 is a schematic structural diagram illustrating another energy conversion device provided in embodiments of the disclosure.

FIG. 3 is a schematic diagram illustrating a specific control structure of an energy conversion device provided in embodiments of the disclosure.

FIG. 4 is a schematic diagram illustrating a specific control structure of another energy conversion device provided in embodiments of the disclosure.

FIG. 5 is a schematic diagram illustrating a specific control structure of another energy conversion device provided in embodiments of the disclosure.

FIG. 6 is a schematic diagram illustrating a specific control structure of another energy conversion device provided in embodiments of the disclosure.

FIG. 7 is a schematic flowchart illustrating a control method based on an energy conversion device provided in embodiments of the disclosure.

FIG. 8 is a schematic diagram illustrating waveforms of $V_{ac}$, $V_{Bus}$, $V_{AB}$, $V_{CD}$, and $i_p$ in one power frequency cycle provided in embodiments of the disclosure.

FIG. 9 to FIG. 12 are schematic diagrams illustrating waveforms of a drive signal for each switch, $V_{AB}$, $V_{CD}$, and $i_p$ when Ge<1 provided in embodiments of the disclosure.

FIG. 13 to FIG. 15 are waveform diagrams illustrating waveforms of a drive signal for each switch, $V_{AB}$, $V_{CD}$, and $i_p$ when Ge>1 provided in embodiments of the disclosure.

FIG. 16 illustrates an energy conversion device with a power factor correction (PFC) module and a direct current/direct current (DC/DC) module provided in embodiments of the disclosure.

FIG. 17 is a schematic structural diagram illustrating a vehicle provided in embodiments of the disclosure.

DETAILED DESCRIPTION

Hereinafter, technical solutions of embodiments of the disclosure will be described clearly and completely with reference to accompanying drawings in the embodiments. Apparently, embodiments described below are merely some embodiments, rather than all embodiments of the disclosure. All other embodiments obtained by those of ordinary skill in the art based on the embodiments without creative efforts shall fall within the protection scope of the disclosure.

The terms "first", "second", and the like used in the specification, the claims, and the accompany drawings of the disclosure are used to distinguish different objects rather than describe a particular order. In addition, the terms "include", "comprise", and "have" as well as variations thereof are intended to cover non-exclusive inclusion. For example, a process, system, product, or device including a series of steps/operations or units is not limited to the listed steps/operations or units, on the contrary, it can optionally include other steps/operations or units that are not listed; alternatively, other steps/operations or units inherent to the process, product, or device can be included either.

The term "embodiment" referred to herein means that particular features, structures, or properties described in conjunction with the embodiments may be defined in at least one embodiment of the disclosure. The phrase "embodiment" appearing in various places in the specification does not necessarily refer to the same embodiment or an independent/alternative embodiment that is mutually exclusive with other embodiments. Those skilled in the art will understand expressly and implicitly that an embodiment described herein may be combined with other embodiments.

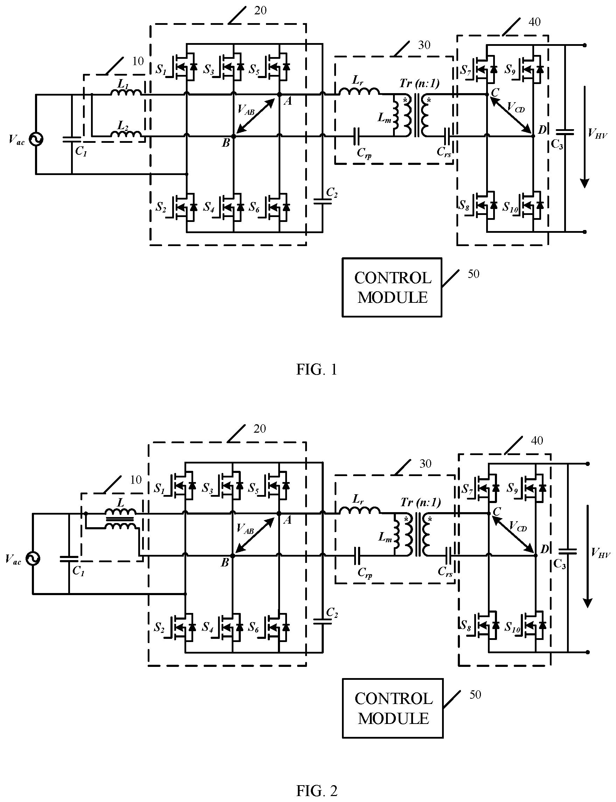

Referring to FIG. 1, FIG. 1 is a schematic structural diagram illustrating an energy conversion device provided in embodiments of the disclosure. As illustrated in FIG. 1, the energy conversion device includes a filter module 10, a primary bridge arm module 20, a resonance module 30, a secondary bridge arm module 40, and a control module 50. The primary bridge arm module 20 includes a first bridge arm, a second bridge arm, and a third bridge arm. The secondary bridge arm module 40 includes a fourth bridge arm and a fifth bridge arm. A frequency of a drive signal for the second bridge arm, a frequency of a drive signal for the third bridge arm, a frequency of a drive signal for the fourth bridge arm, and a frequency of a drive signal for the fifth bridge arm each are higher than a frequency of a drive signal for the first bridge arm. A first end of the filter module 10 is connected with a first alternating current (AC) end, a second end of the filter module 10 is connected with a bridge arm midpoint of the third bridge arm and a first end of the resonance module 30, a third end of the filter module 10 is connected with a bridge arm midpoint of the second bridge arm and a second end of the resonance module 30, and a bridge arm midpoint of the first bridge arm is connected with a second AC end. A third end of the resonance module 30 is connected with a bridge arm midpoint of the fourth bridge arm, and a fourth end of the resonance module 30 is connected with a bridge arm midpoint of the fifth bridge arm. A first end of the first bridge arm is connected with a first end of the second bridge arm and a first end of the third bridge arm, and a second end of the first bridge arm is connected with a second end of the second bridge arm and a second end of the third bridge arm. A first end of the fourth bridge arm is connected with a first end of the fifth bridge arm and a first direct current (DC) end, and a second end of the fourth bridge arm is connected with a second end of the fifth bridge arm and a second DC end. The control module 50 is configured to determine a phase shift angle of a target bridge arm relative to a reference bridge arm according to a demand gain of the energy conversion device, a first sampled current, a second sampled current, a first sampled voltage, and a second sampled voltage, to enable soft switching of switches in the primary bridge arm module 20 and the secondary bridge arm module 40. The reference bridge arm is one of the second bridge arm, the third bridge arm, the fourth bridge arm, and the fifth bridge arm. The target bridge arm is a bridge arm(s) other than the reference bridge arm among the second bridge arm, the third bridge arm, the fourth bridge arm, and the fifth bridge arm. The phase shift angle of the target bridge arm relative to the reference bridge arm is used for controlling a timing of a drive signal for the target bridge arm. The first sampled current is a sampled current at the first end of the filter module 10. The second sampled current is a sampled current between the second end of the fifth bridge arm and the second DC end. The first sampled voltage is a sampled voltage between the first AC end and the second AC end or a sampled voltage between the first end of the third bridge arm and the second end of the third bridge arm. The second sampled voltage is a sampled voltage between the first DC end and the second DC end.

As illustrated in FIG. 1, the first bridge arm includes a first switch $S_1$ and a second switch $S_2$. A first end of the first switch $S_1$ is connected with the first end of the first bridge arm, a second end of the first switch $S_1$ is connected with a first end of the second switch $S_2$ and the bridge arm midpoint of the first bridge arm, and a second end of the second switch $S_2$ is connected with the second end of the first bridge arm. The drive signal for the first bridge arm includes a first drive signal and a second drive signal. The control module 50 can be configured to control a drive module to send the first drive signal to a third end of the first switch $S_1$, where the first drive signal is used for controlling the first switch $S_1$ to be on or off. The control module 50 can be configured to control the drive module to send the second drive signal to a third end of the second switch $S_2$, where the second drive signal is used for controlling the second switch $S_2$ to be on or off. The first drive signal has a same frequency as the second drive signal, and the first drive signal and the second drive signal are complementary signals, that is, in one cycle of the first drive signal, one of the first switch $S_1$ and the second switch $S_2$ is on, while another of the first switch $S_1$ and the second switch $S_2$ is off. Exemplarily, the duty cycle of the first drive signal and the duty cycle of the

**EP 4 779 858 A1**

second drive signal each are 50% (ignoring dead time). Exemplarily, the frequency of the first drive signal and the frequency of the second drive signal each are a grid frequency (also be referred to as power frequency). For example, the grid frequency is 50 Hz.

As illustrated in FIG. 1, the second bridge arm includes a third switch $S_3$ and a fourth switch $S_4$. A first end of the third switch $S_3$ is connected with the first end of the second bridge arm, a second end of the third switch $S_3$ is connected with a first end of the fourth switch $S_4$ and the bridge arm midpoint of the second bridge arm, and a second end of the fourth switch $S_4$ is connected with the second end of the second bridge arm. The drive signal for the second bridge arm includes a third drive signal and a fourth drive signal. The control module 50 can be configured to control the drive module to send the third drive signal to a third end of the third switch $S_3$, where the third drive signal is used for controlling the third switch $S_3$ to be on or off. The control module 50 can be configured to control the drive module to send the fourth drive signal to a third end of the fourth switch $S_4$, where the fourth drive signal is used for controlling the fourth switch $S_4$ to be on or off. The third drive signal has a same frequency as the fourth drive signal, and the third drive signal and the fourth drive signal are complementary signals, that is, in one cycle of the third drive signal, one of the third switch $S_3$ and the fourth switch $S_4$ is on, while another of the third switch $S_3$ and the fourth switch $S_4$ is off. Exemplarily, the duty cycle of the third drive signal and the duty cycle of the fourth drive signal each are 50% (ignoring dead time). The frequency of the third drive signal and the frequency of the fourth drive signal each are a switching frequency. For example, the switching frequency is 50 KHz.

As illustrated in FIG. 1, the third bridge arm includes a fifth switch $S_5$ and a sixth switch $S_6$. A first end of the fifth switch $S_5$ is connected with the first end of the third bridge arm, a second end of the fifth switch $S_5$ is connected with a first end of the sixth switch $S_6$ and the bridge arm midpoint of the third bridge arm, and a second end of the sixth switch $S_6$ is connected with the second end of the third bridge arm. The drive signal for the third bridge arm includes a fifth drive signal and a sixth drive signal. The control module 50 can be configured to control the drive module to send the fifth drive signal to a third end of the fifth switch $S_5$, where the fifth drive signal is used for controlling the fifth switch $S_5$ to be on or off. The control module 50 can be configured to control the drive module to send the sixth drive signal to a third end of the sixth switch $S_6$, where the sixth drive signal is used for controlling the sixth switch $S_6$ to be on or off. The fifth drive signal has a same frequency as the sixth drive signal, and the fifth drive signal and the sixth drive signal are complementary signals, that is, in one cycle of the fifth drive signal, one of the fifth switch $S_5$ and the sixth switch $S_6$ is on, while another of the fifth switch $S_5$ and the sixth switch $S_6$ is off. Exemplarily, the duty cycle of the fifth drive signal and the duty cycle of the sixth drive signal each are 50% (ignoring dead time). The frequency of the fifth drive signal and the frequency of the sixth drive signal each are a switching frequency. For example, the switching frequency is 50 KHz.

As illustrated in FIG. 1, the fourth bridge arm includes a seventh switch $S_7$ and an eighth switch $S_8$. A first end of the seventh switch $S_7$ is connected with the first end of the fourth bridge arm, a second end of the seventh switch $S_7$ is connected with a first end of the eighth switch $S_8$ and the bridge arm midpoint of the fourth bridge arm, and a second end of the eighth switch $S_8$ is connected with the second end of the fourth bridge arm. The drive signal for the fourth bridge arm includes a seventh drive signal and an eighth drive signal. The control module 50 can be configured to control the drive module to send the seventh drive signal to a third end of the seventh switch $S_7$, where the seventh drive signal is used for controlling the seventh switch $S_7$ to be on or off. The control module 50 can be configured to control the drive module to send the eighth drive signal to a third end of the eighth switch $S_8$, where the eighth drive signal is used for controlling the eighth switch $S_8$ to be on or off. The seventh drive signal has a same frequency as the eighth drive signal, and the seventh drive signal and the eighth drive signal are complementary signals, that is, in one cycle of the seventh drive signal, one of the seventh switch $S_7$ and the eighth switch $S_8$ is on, while another of the seventh switch $S_7$ and the eighth switch $S_8$ is off. Exemplarily, the duty cycle of the seventh drive signal and the duty cycle of the eighth drive signal each are 50% (ignoring dead time). The frequency of the seventh drive signal and the frequency of the eighth drive signal each are a switching frequency. For example, the switching frequency is 50 KHz.

As illustrated in FIG. 1, the fifth bridge arm includes a ninth switch $S_9$ and a tenth switch $S_{10}$. A first end of the ninth switch $S_9$ is connected with the first end of the fifth bridge arm, a second end of the ninth switch $S_9$ is connected with a first end of the tenth switch $S_{10}$ and the bridge arm midpoint of the fifth bridge arm, and a second end of the tenth switch $S_{10}$ is connected with the second end of the fifth bridge arm. The drive signal for the fifth bridge arm includes a ninth drive signal and a tenth drive signal. The control module 50 can be configured to control the drive module to send the ninth drive signal to a third end of the ninth switch $S_9$, where the ninth drive signal is used for controlling the ninth switch $S_9$ to be on or off. The control module 50 can be configured to control the drive module to send the tenth drive signal to a third end of the tenth switch $S_{10}$, where the tenth drive signal is used for controlling the tenth switch $S_{10}$ to be on or off. The ninth drive signal has a same frequency as the tenth drive signal, and the ninth drive signal and the tenth drive signal are complementary signals, that is, in one cycle of the ninth drive signal, one of the ninth switch $S_9$ and the tenth switch $S_{10}$ is on, while another of the ninth switch $S_9$ and the tenth switch $S_{10}$ is off. Exemplarily, the duty cycle of the ninth drive signal and the duty cycle of the tenth drive signal each are 50% (ignoring dead time). The frequency of the ninth drive signal and the frequency of the tenth drive signal each are a switching frequency. For example, the switching frequency is 50 KHz.

As illustrated in FIG. 1, switches in the primary bridge arm module 20 include the first switch $S_1$, the second switch $S_2$, the third switch $S_3$, the fourth switch $S_4$, the fifth switch $S_5$, and the sixth switch $S_6$. Switches in the secondary bridge arm

7

module 40 include the seventh switch $S_7$, the eighth switch $S_8$, the ninth switch $S_9$, and the tenth switch $S_{10}$.

The first switch $S_1$, the second switch $S_2$, the third switch $S_3$, the fourth switch $S_4$, the fifth switch $S_5$, the sixth switch $S_6$, the seventh switch $S_7$, the eighth switch $S_8$, the ninth switch $S_9$, and the tenth switch $S_{10}$ each may be a metal-oxide-semiconductor field-effect transistor (MOSFET) or an insulate-gate bipolar transistor (IGBT). The MOSFET can also be referred to as MOS tube or MOS transistor. Exemplarily, switches in FIG. 1 each are an N-type MOS transistor, and the N-type MOS transistor can be referred to as NOMS tube. The MOSFET may be a silicon carbide (SiC) MOSFET or a gallium nitride (GaN) MOSFET. The SiC MOSFET is a MOSFET made of silicon carbide material, and the GaN MOSFET is a MOSFET made of gallium nitride material.

The phase shift angle of the target bridge arm relative to the reference bridge arm refers to a phase difference between a start position of the drive signal for the target bridge arm in one cycle and a start position of a drive signal for the reference bridge arm in one cycle.

The soft switching is a process of introducing resonance before and after turn-off and turn-on of a switch, allowing the switch to achieve a zero voltage switch (that is, a voltage across the switch is reduced to zero before the switch is turned on) or a zero current switch (that is, a current through the switch is reduced to zero before the switch is turned off), which can eliminate overlap of a voltage and a current during turn-off and turn-on of the switch and can reduce a change rate of the voltage and the current, thus significantly reducing or even eliminating switching loss, and further significantly reducing switching noise.

In a possible embodiment, the energy conversion device can implement an alternating current/direct current (AC/DC) converting function. In this case, the first AC end and the second AC end serve as AC input ends, the first DC end and the second DC end serve as DC output ends, and the energy conversion device can convert an inputted AC into a DC for output.

In a possible embodiment, the energy conversion device can implement a direct current/alternating current (DC/AC) converting function. In this case, the first AC end and the second AC end serve as AC output ends, the first DC end and the second DC end serve as DC input ends, and the energy conversion device can convert an inputted DC into an AC for output.

Exemplarily, the energy conversion device may be an on-board charger for vehicles. The on-board charger may be a bidirectional on-board charger capable of supporting both converting of AC to DC and converting of DC to AC.

The energy conversion device of embodiments of the disclosure has less bridge arms and has no need for the electrolytic capacitor compared to a two-stage architecture including a power factor correction (PFC) module and a direct current/direct current (DC/DC) module, which can reduce the size and cost of the energy conversion device. The control module 50 of the energy conversion device can determine the phase shift angle of the target bridge arm relative to the reference bridge arm according to the demand gain of the energy conversion device, the first sampled current, the second sampled current, the first sampled voltage, and the second sampled voltage, to enable soft switching of switches in the primary bridge arm module 20 and the secondary bridge arm module 40, which can reduce switching loss, thereby improving a conversion efficiency of the energy conversion device.

Optionally, the resonance module 30 includes a resonance inductor $L_r$, a first resonance capacitor $C_{rp}$, a second resonance capacitor $C_{rs}$, and a transformer Tr. The resonance inductor $L_r$ and the first resonance capacitor $C_{rp}$ each are connected in series with a primary winding of the transformer Tr, and the second resonance capacitor $C_{rs}$ is connected in series with a secondary winding of the transformer Tr.

A first end of the primary winding of the transformer Tr is connected with a first end of an excitation inductor $L_m$, and a second end of the primary winding of the transformer Tr is connected with a second end of the excitation inductor $L_m$.

The primary winding of the transformer Tr may be integrated with the excitation inductor, or the excitation inductor may also be independent of the primary winding of the transformer. FIG. 1 illustrates a case where the excitation inductor is independent of the primary winding of the transformer.

As illustrated in FIG. 1, a first end of the resonance inductor $L_r$ is connected with the bridge arm midpoint of the third bridge arm, a second end of the resonance inductor $L_r$ is connected with the first end of the primary winding of the transformer Tr and the first end of the excitation inductor $L_m$, the second end of the primary winding of the transformer Tr is connected with the second end of the excitation inductor $L_m$ and a first end of the first resonance capacitor $C_{rp}$, and a second end of the first resonance capacitor $C_{rp}$ is connected with the bridge arm midpoint of the second bridge arm. A first end of the secondary winding of the transformer Tr is connected with the bridge arm midpoint of the fourth bridge arm, a second end of the secondary winding of the transformer Tr is connected with a first end of the second resonance capacitor $C_{rs}$, and a second end of the second resonance capacitor $C_{rs}$ is connected with the bridge arm midpoint of the fifth bridge arm.

It is to be noted that, the connection in the resonance module 30 of FIG. 1 is only one possible connection. The resonance inductor $L_r$ and the first resonance capacitor $C_{rp}$ can be connected in series with the primary winding of the transformer Tr in any manner (as an example, the resonance inductor $L_r$ and the first resonance capacitor $C_{rp}$ connected in series with the resonance inductor $L_r$ are connected between the bridge arm midpoint of the third bridge arm and the first end of the primary winding of the transformer Tr; as another example, the resonance inductor $L_r$ and the first resonance

capacitor $C_{rp}$ connected in series with the resonance inductor $L_r$ are connected between the bridge arm midpoint of the second bridge arm and the second end of the primary winding of the transformer Tr; as another example, the resonance inductor $L_r$ is connected in series between the bridge arm midpoint of the third bridge arm and the first end of the primary winding of the transformer Tr, and the first resonance capacitor $C_{rp}$ is connected in series between the bridge arm midpoint of the second bridge arm and the second end of the primary winding of the transformer Tr; as another example, the first resonance capacitor $C_{rp}$ is connected in series between the bridge arm midpoint of the third bridge arm and the first end of the primary winding of the transformer Tr, and the resonance inductor $L_r$ is connected in series between the bridge arm midpoint of the second bridge arm and the second end of the primary winding of the transformer Tr), and the second resonance capacitor $C_{rs}$ can be connected in series with the secondary winding of the transformer Tr in any manner, (as an example, the second resonance capacitor $C_{rs}$ is connected in series between the first end of the secondary winding of the transformer Tr and the bridge arm midpoint of the fourth bridge arm; as another example, the second resonance capacitor $C_{rs}$ is connected in series between the second end of the secondary winding of the transformer Tr and the bridge arm midpoint of the fifth bridge arm), which is not limited in embodiments of the disclosure.

The frequency for the second bridge arm, the frequency for the third bridge arm, the frequency for the fourth bridge arm, and the frequency for the fifth bridge arm each are a switching frequency, and the switching frequency is greater than a resonant frequency of the resonance module 30.

Optionally, as illustrated in FIG. 1, the filter module 10 includes a first inductor $L_1$ and a second inductor $L_2$. A first end of the first inductor $L_1$ is connected with a first end of the second inductor $L_2$ and the first AC end, a second end of the first inductor $L_1$ is connected with the bridge arm midpoint of the third bridge arm, and a second end of the second inductor $L_2$ is connected with the bridge arm midpoint of the second bridge arm.

The first inductor $L_1$ and the second inductor $L_2$ are inductors at an AC side, to provide filtering and energy storage functions.

Optionally, as illustrated in FIG. 2, the filter module 10 includes a coupled inductor. A first end of the coupled inductor is connected with a second end of the coupled inductor and the first AC end, a third end of the coupled inductor is connected with the bridge arm midpoint of the third bridge arm, and a fourth end of the coupled inductor is connected with the bridge arm midpoint of the second bridge arm.

In embodiments of the disclosure, by adopting the coupled inductor, the first inductor $L_1$ and the second inductor $L_2$ in FIG. 1 can be integrated into one inductor L, which can reduce the size of the filter module 10, and further reduce the size of the energy conversion device, thereby reducing the cost and improving a power density of the energy conversion device.

Optionally, as illustrated in FIG. 1 or FIG. 2, the energy conversion device further includes a first filter capacitor $C_1$, a second filter capacitor $C_2$, and a third filter capacitor $C_3$. Two ends of the first filter capacitor $C_1$ are respectively connected with the first AC end and the second AC end, two ends of the second filter capacitor $C_2$ are respectively connected with the first end of the third bridge arm and the second end of the third bridge arm, and two ends of the third filter capacitor $C_3$ are respectively connected with the first end of the fifth bridge arm and the second end of the fifth bridge arm.

The first filter capacitor $C_1$ is a filter capacitor at the AC side. The second filter capacitor $C_2$ is a high-frequency filter capacitor at a primary side, which is used to absorb a high-frequency ripple of a switch. The third filter capacitor $C_3$ is a high-frequency filter capacitor at a DC side, which is used to absorb a high-frequency ripple.

Optionally, the control module 50 configured to determine the phase shift angle of the target bridge arm relative to the reference bridge arm according to the demand gain of the energy conversion device, the first sampled current, the second sampled current, the first sampled voltage, and the second sampled voltage is configured to: determine a phase shift angle between a first voltage waveform and a second voltage waveform according to the first sampled current, the second sampled current, the first sampled voltage, and the second sampled voltage, where the first voltage waveform is a waveform of a voltage between the bridge arm midpoint of the third bridge arm and the bridge arm midpoint of the second bridge arm, and the second voltage waveform is a waveform of a voltage between the bridge arm midpoint of the fourth bridge arm and the bridge arm midpoint of the fifth bridge arm; and determine the phase shift angle of the target bridge arm relative to the reference bridge arm according to the phase shift angle between the first voltage waveform and the second voltage waveform, the demand gain of the energy conversion device, a turns ratio of the transformer Tr, the first sampled voltage, and the second sampled voltage.

As illustrated in FIG. 1 or FIG. 2, a voltage between the bridge arm midpoint B of the second bridge arm and the bridge arm midpoint $A$ of the third bridge arm is $V_{AB}$. A voltage between the bridge arm midpoint C of the fourth bridge arm and the bridge arm midpoint D of the fifth bridge arm is $V_{CD}$. The first voltage waveform is a waveform of $V_{AB}$, and the second voltage waveform is a waveform of $V_{CD}$.

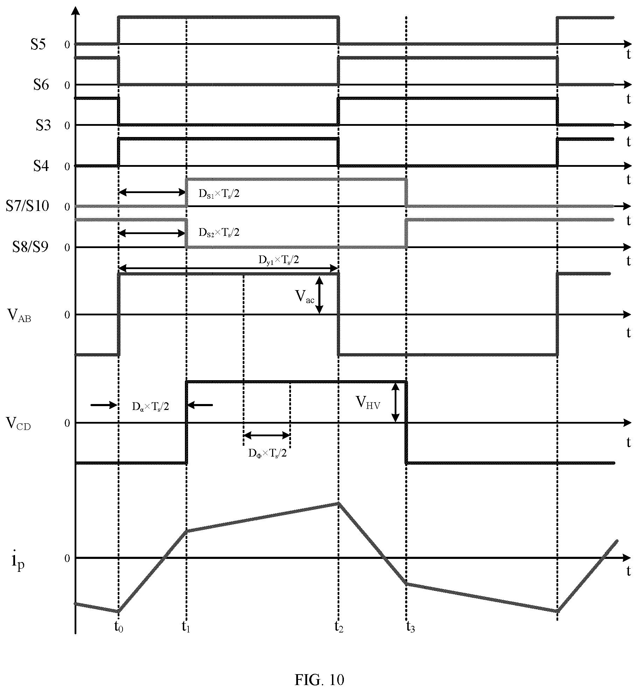

The phase shift angle between the first voltage waveform and the second voltage waveform refers to a phase shift angle of the second voltage waveform relative to the first voltage waveform, that is, a phase difference between high-level centerlines of $V_{CD}$ and $V_{AB}$ within one cycle. For example, as illustrated in FIG. 10 to FIG. 15, the phase shift angle between the first voltage waveform $V_{AB}$ and the second voltage waveform $V_{CD}$ is $D_\Phi$, and a time difference between high-level centerlines of $V_{CD}$ and $V_{AB}$ within one cycle ($T_s$) is $D_\Phi \times T_s/2$.

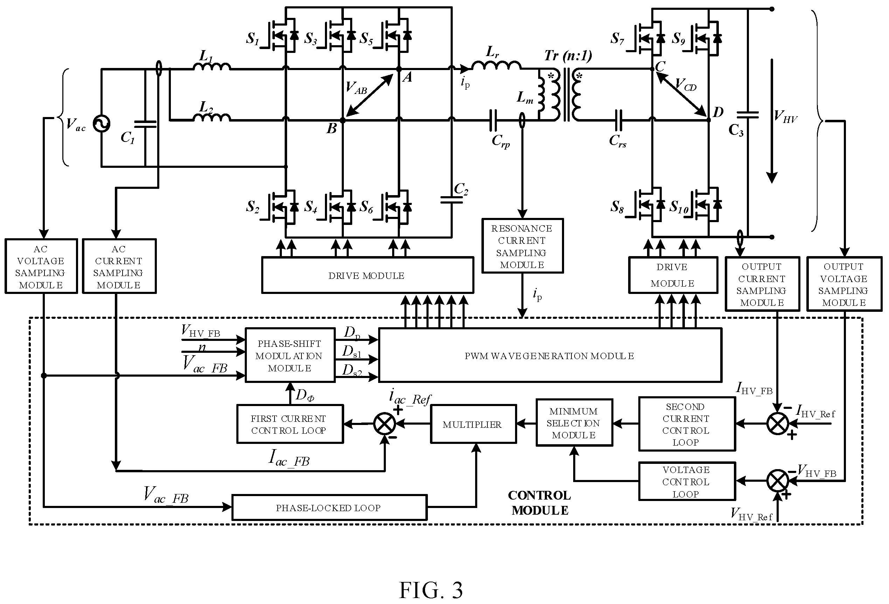

Referring to FIG. 3, FIG. 3 is a schematic diagram illustrating a specific control structure of an energy conversion device provided in embodiments of the disclosure. FIG. 3 is obtained on the basis of FIG. 1. As illustrated in FIG. 3, on the basis of FIG. 1, the control module 50 includes a phase-locked loop, a first current control loop, a second current control loop, a voltage control loop, a multiplier, a minimum selection module, and a phase-shift modulation module. The energy conversion device in FIG. 3 can be configured to convert an inputted AC into a DC for output.

The phase-locked loop is configured to output a first loop calculation result by performing loop calculation on the first sampled voltage ($V_{ac\_FB}$ in FIG. 3). The first sampled voltage $V_{ac\_FB}$ is a sampled voltage between the first AC end and the second AC end. The first sampled voltage $V_{ac\_FB}$ is obtained by sampling by an AC voltage sampling module in FIG. 3. The AC voltage sampling module is configured to sample a voltage between the first AC end and the second AC end.

The second current control loop is configured to output a second loop calculation result by performing loop calculation on a result of a subtraction operation between the second sampled current ($I_{HV\_FB}$ in FIG. 3) and a first reference current ($I_{HV\_Ref}$ in FIG. 3). The first reference current $I_{HV\_Ref}$ is an output demand current currently set by the energy conversion device. The second sampled current $I_{HV\_FB}$ is obtained by sampling by an output current sampling module in FIG. 3. The output current sampling module is configured to sample a current between the second end of the fifth bridge arm and the second DC end. The current between the second end of the fifth bridge arm and the second DC end may be a filtered current (e.g., a current filtered by the third filter capacitor $C_3$ in FIG. 3).

The voltage control loop is configured to output a third loop calculation result by performing loop calculation on a result of a subtraction operation between the second sampled voltage ($V_{HV\_FB}$ in FIG. 3) and a second reference voltage ($V_{HV\_Ref}$ in FIG. 3). The second reference voltage $V_{HV\_Ref}$ is an output demand voltage currently set by the energy conversion device. The second sampled voltage $V_{HV\_FB}$ is obtained by sampling by an output voltage sampling module in FIG. 3. The output voltage sampling module is configured to sample a voltage between the first DC end and the second DC end.

The minimum selection module is configured to select a minimum value from the second loop calculation result and the third loop calculation result.

The multiplier is configured to obtain a second reference current ($i_{ac\_Ref}$ in FIG. 3) by multiplying the minimum value selected from the second loop calculation result and the third loop calculation result with the first loop calculation result.

The first current control loop is configured to output the phase shift angle ($D_\Phi$ in FIG.3) between the first voltage waveform and the second voltage waveform by performing loop calculation on a result of a subtraction operation between the first sampled current ($I_{ac\_FB}$ in FIG. 3) and the second reference current $i_{ac\_Ref}$ (i.e., $i_{ac\_Ref}$ - $I_{ac\_FB}$). The $I_{ac\_FB}$ is obtained by sampling by an AC current module in FIG. 3. The AC current module is configured to sample a sampled current at the first end of the filter module.

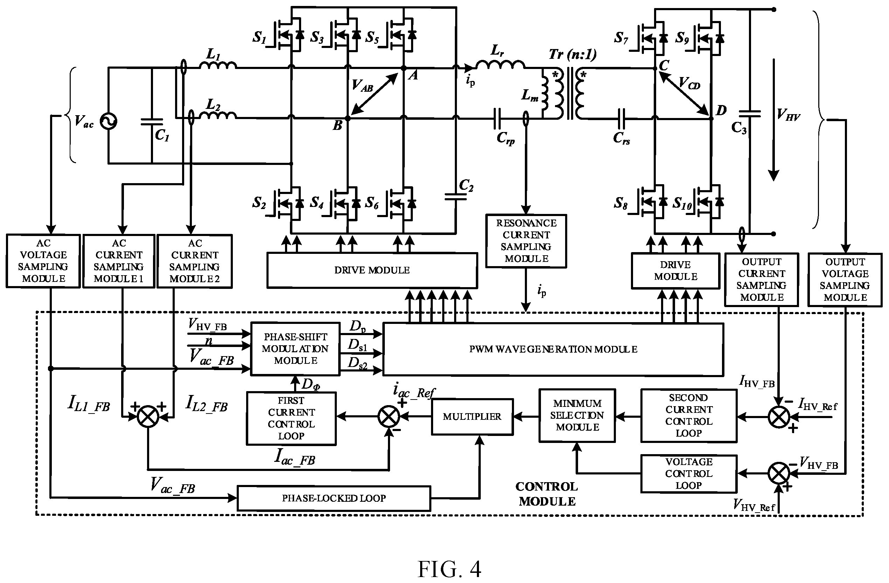

Referring to FIG. 4, FIG. 4 is a schematic diagram illustrating a specific control structure of another energy conversion device provided in embodiments of the disclosure. As illustrated in FIG. 4, the first sampled current is the sum of a sampled current on the first inductor $L_1$ ($I_{L1\_FB}$ in FIG. 4) and a sampled current on the second inductor $L_2$ ($I_{L2\_FB}$ in FIG. 4). The $I_{L1\_FB}$ is obtained by sampling by an AC current module 1 in FIG. 4, and the $I_{L2\_FB}$ is obtained by sampling by an AC current module 2 in FIG. 4. The AC current module 1 is configured to sample a current flowing through the first inductor $L_1$, and the AC current module 2 is configured to sample a current flowing through the second inductor $L_2$.

In FIG. 3 and FIG. 4, the first sampled voltage is a sampled voltage between the first AC end and the second AC end.

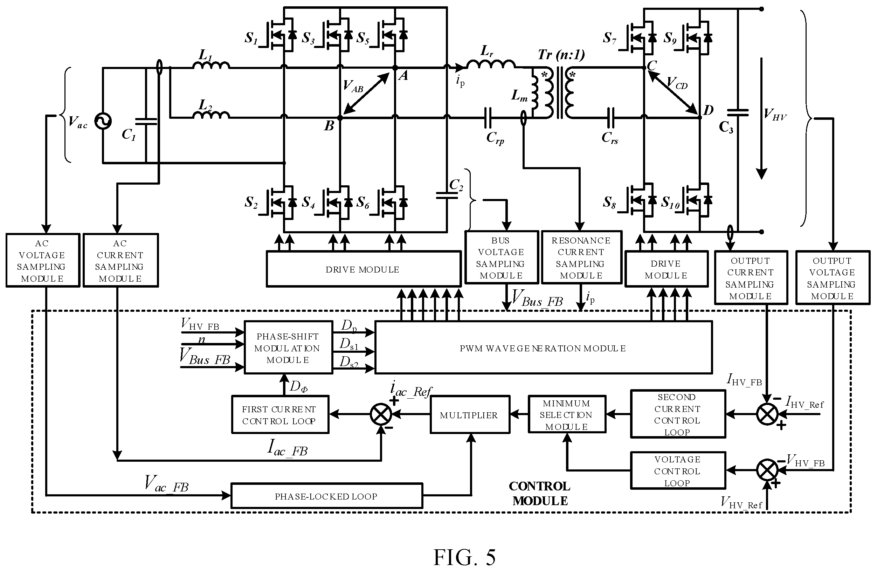

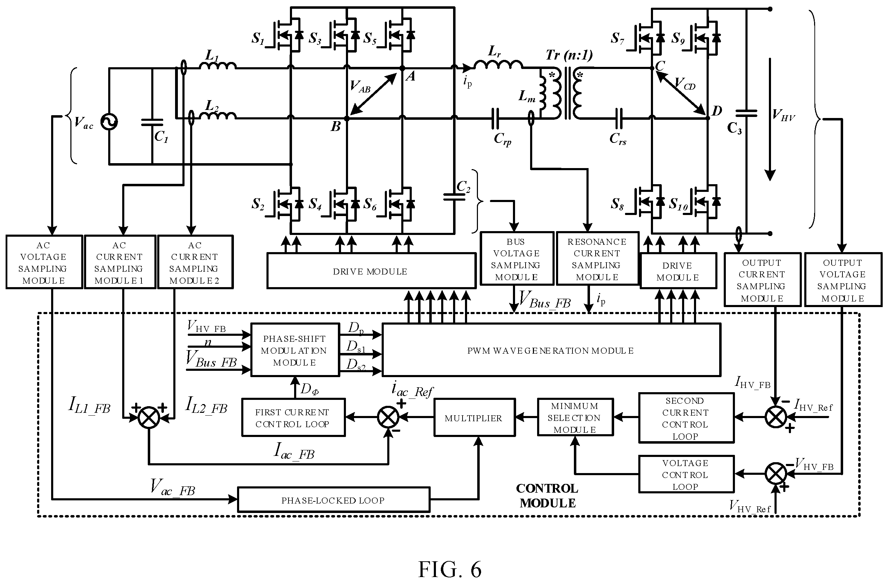

Compared to FIG. 3 and FIG. 4, in FIG. 5 and FIG. 6, the first sampled voltage is a sampled voltage between the first end of the third bridge arm and the second end of the third bridge arm, that is, a voltage across the second filter capacitor $C_2$. As illustrated in FIG. 5 and FIG. 6, a bus voltage sampling module is configured to sample a voltage $V_{Bus\_FB}$ across the second filter capacitor $C_2$. A resonance current sampling module is configured to sample a current $i_p$ on the resonance inductor $L_r$.

The phase-shift modulation module is configured to determine the phase shift angle of the target bridge arm relative to the reference bridge arm according to the phase shift angle $D_\Phi$ between the first voltage waveform and the second voltage waveform, the demand gain $G_e$ of the energy conversion device, the turns ratio n of the transformer Tr, the first sampled voltage ($V_{ac\_FB}$ in FIG. 3 or FIG. 4, or $V_{Bus\_FB}$ in FIG. 5 or FIG. 6), and the second sampled voltage $V_{HV\_FB}$.

In FIG. 3, a PWM wave generation module is a pulse width modulation (PWM) module, and is configured to generate a wave generation signal for each switch according to the phase shift angle of the target bridge arm relative to the reference bridge arm. The drive module is configured to generate a drive signal for each switch after amplifying and isolating the wave generation signal for each switch, and a drive signal for a switch is used for driving the switch to be on or off.

When FIG. 3 illustrates implementing of an AC/DC function, $V_{ac}$ in FIG. 3 is an AC input power supply from the grid, the first filter capacitor $C_1$ is an AC input filter capacitor; the first inductor $L_1$ and the second inductor $L_2$ each are an AC input inductor, to provide filtering and energy storage functions. The first switch $S_1$ and the second switch $S_2$ in FIG. 3 operate at a grid frequency (e.g., 50Hz), and the first bridge arm composed of the first switch $S_1$ and the second switch $S_2$ is

called a slow bridge arm; the third switch $S_3$ and the fourth switch $S_4$ form the second bridge arm, the fifth switch $S_5$ and the sixth switch $S_6$ form the third bridge arm, the second bridge arm and the third bridge arm each are called a fast bridge arm, these switches operate at a switching frequency, and a voltage between the bridge arm midpoint A of the third bridge arm and the bridge arm midpoint B of the second bridge arm is $V_{AB}$. The second filter capacitor $C_2$ is a high-frequency filter capacitor at the primary side, which is used to absorb a high-frequency ripple of the switch. The resonance inductor $L_r$, the first resonance capacitor $C_{rp}$, and the second resonance capacitor $C_{rs}$ form a resonant circuit, the excitation inductor $L_m$ is an excitation inductor of the transformer Tr, and $n$:1 represents electrical insulation and a voltage conversion ratio between the primary side and the secondary side provided by the transformer Tr; the seventh switch $S_7$ and the eighth switch $S_8$ form the fourth bridge arm, the ninth switch $S_9$ and the tenth switch $S_{10}$ form the fifth bridge arm, the fourth bridge arm and the fifth bridge arm each are also called a fast bridge arms, these switches also operate at a switching frequency, and a voltage between the bridge arm midpoint C of the fourth bridge arm and the bridge arm midpoint D of the fifth bridge arm is $V_{CD}$. The third filter capacitor $C_3$ is a high-frequency output filter capacitor, which is used to absorb a high-frequency ripple.

In the energy conversion device of FIG. 3, the control module 50 can adopt dual-loop control. To meet a charging requirement of the energy conversion device for constant voltage and constant current, the second current control loop and the voltage control loop in the control module 50 are competitively controlled, and a minimum value of outputs of the two loops is used to determine a reference current (i.e., the second reference current $i_{ac\_Ref}$) for the first current control loop. The first current control loop is configured to track and control the first sampled current $I_{ac\_FB}$ and the first sampled voltage $V_{ac\_FB}$, and an output of the first current control loop is used to determine the phase shift angle $D_{\Phi}$ between a midpoint voltage $V_{AB}$ of primary bridge arms (including the second bridge arm and the third bridge arm) and a midpoint voltage $V_{CD}$ of secondary bridge arms (including the fourth bridge arm and the fifth bridge arm). For convenience of control, the third bridge arm (including the fifth switch $S_5$ and the sixth switch $S_6$) is used as a reference, if a phase shift angle (or a phase shift time) of the second bridge arm (including the third switch $S_3$ and the fourth switch $S_4$) relative to the third bridge arm is defined as $D_p$, a phase shift angle (or a phase shift time) of the fourth bridge arm (including the seventh switch $S_7$ and the eighth switch $S_8$) relative to the third bridge arm is defined as $D_{s1}$, and a phase shift angle (or a phase shift time) of the fifth bridge arm (including the ninth switch $S_9$ and the tenth switch $S_{10}$) relative to the third bridge arm is defined as $D_{s2}$, the phase-shift modulation module is configured to determine values of $D_p$, $D_{s1}$, and $D_{s2}$ according to $D_{\Phi}$ outputted by the first current control loop, the first sampled voltage $V_{ac\_FB}$, the second sampled voltage $V_{HV\_FB}$, and the turns ratio n of the transformer Tr, the PWM wave generation module of the control module 50 is configured to generate a wave generation signal, and the drive module is configured to generate a drive signal for each switch, to control the third switch $S_3$, the fourth switch $S_4$, the fifth switch $S_5$, the sixth switch $S_6$, the seventh switch $S_7$, the eighth switch $S_8$, the ninth switch $S_9$, and the tenth switch $S_{10}$.

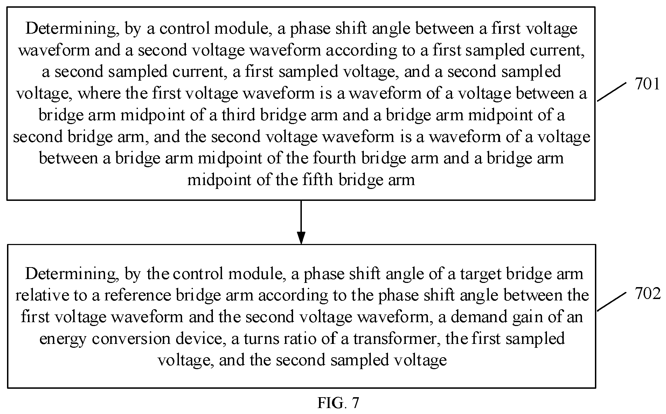

Based on the energy conversion device in FIG. 3 or FIG. 4 or FIG. 5 or FIG. 6, embodiments of the disclosure provide a control method based on the energy conversion device. Referring to FIG. 7, FIG. 7 is a schematic flowchart illustrating a control method based on an energy conversion device provided in embodiments of the disclosure. As illustrated in FIG. 7, the control method based on the energy conversion device includes the following.

701, a control module determines a phase shift angle between a first voltage waveform and a second voltage waveform according to a first sampled current, a second sampled current, a first sampled voltage, and a second sampled voltage, where the first voltage waveform is a waveform of a voltage between a bridge arm midpoint of a third bridge arm and a bridge arm midpoint of a second bridge arm, and the second voltage waveform is a waveform of a voltage between a bridge arm midpoint of the fourth bridge arm and a bridge arm midpoint of the fifth bridge arm.

The first sampled current is a sampled current at a first end of a filter module 10, the second sampled current is a sampled current between a second end of the fifth bridge arm and a second DC end, the first sampled voltage is a sampled voltage between a first AC end and the second AC end (see FIG. 3 and FIG. 4) or a sampled voltage between a first end of the third bridge arm and a second end of the third bridge arm (see FIG. 5 and FIG. 6), and the second sampled voltage is a sampled voltage between a first DC end and the second DC end.

The operations at 701 may be performed by the phase-locked loop, the first current control loop, the second current control loop, the voltage control loop, the multiplier, and the minimum selection module in the control module of the energy conversion device in FIG. 3, FIG. 4, FIG. 5, or FIG. 6.

Specifically, in FIG. 3 to FIG. 6, an AC voltage sampling module obtains the first sampled voltage $V_{ac\_FB}$ by sampling a voltage between the first AC end and the second AC end. The phase-locked loop outputs a first loop calculation result by performing loop calculation on the first sampled voltage $V_{ac\_FB}$. An output current sampling module obtains a second sampled current $I_{HV\_FB}$ by sampling a current between the second end of the fifth bridge arm and the second DC end. The second current control loop outputs a second loop calculation result by performing loop calculation on a result of a subtraction operation between the second sampled current $I_{HV\_FB}$ and a first reference current $I_{HV\_Ref}$, where the first reference current $I_{HV\_Ref}$ is an output demand current currently set by the energy conversion device. An output voltage sampling module samples a voltage between the first DC end and the second DC end. The voltage control loop outputs a third loop calculation result by performing loop calculation on a result of a subtraction operation between the second sampled voltage $V_{HV\_FB}$ and a second reference voltage $V_{HV\_Ref}$, where the second reference voltage $V_{HV\_Ref}$ is an output demand voltage currently set by the energy conversion device. The minimum selection module selects a minimum value from the second loop calculation result and the third loop calculation result. The multiplier obtains a second reference current $i_{ac\_Ref}$ by multiplying the first loop calculation result with the minimum value selected from the second loop calculation result and the third loop calculation result. The first current control loop in FIG. 3 or FIG. 5 outputs the phase shift angle $D_\Phi$ between the first voltage waveform $V_{AB}$ and the second voltage waveform $V_{CD}$ by performing loop calculation on a result of a subtraction operation between the first sampled current $I_{ac\_FB}$ and a second reference current $i_{ac\_Ref}$ (i.e., $i_{ac\_Ref}$ - $I_{ac\_FB}$), where an AC current module in FIG. 3 or FIG. 5 samples a current at the first end of the filter module, that is, the first sampled current $I_{ac\_FB}$.

The first current control loop in FIG. 4 or FIG. 6 outputs the phase shift angle $D_\Phi$ between the first voltage waveform $V_{AB}$ and the second voltage waveform $V_{CD}$ by performing loop calculation on the result of the subtraction operation between the first sampled current $I_{ac\_FB}$ and the second reference current $i_{ac\_Ref}$ (i.e., $i_{ac\_Ref}$ - $I_{ac\_FB}$), where the AC current module in FIG. 4 or FIG. 6 obtains $I_{L1\_FB}$ by sampling a current flowing through the first inductor $L_1$, the AC current module 2 in FIG. 4 or FIG. 6 obtains $I_{L2\_FB}$ by sampling a current flowing through the second inductor $L_2$, and the first sampled current is the sum of $I_{L1\_FB}$ and $I_{L2\_FB}$, that is, the first sampled current $I_{ac\_FB}$ = $I_{L1\_FB}$ + $I_{L2\_FB}$.

702, the control module determines a phase shift angle of a target bridge arm relative to a reference bridge arm according to the phase shift angle between the first voltage waveform and the second voltage waveform, the demand gain of the energy conversion device, a turns ratio of a transformer, the first sampled voltage, and the second sampled voltage.

The demand gain of the energy conversion device is defined as $G_e = n \times V_{CD}/V_{AB}$, where n represents the turns ratio of the transformer Tr (i.e., the turns ratio of a primary winding of the transformer Tr to a secondary winding of the transformer Tr), $V_{AB}$ represents the first voltage waveform, and $V_{CD}$ represents the second voltage waveform.

The operations at 702 may be performed by the phase-shift modulation module in the control module. A control strategy for phase-shift modulation in the phase-shift modulation module is illustrated in

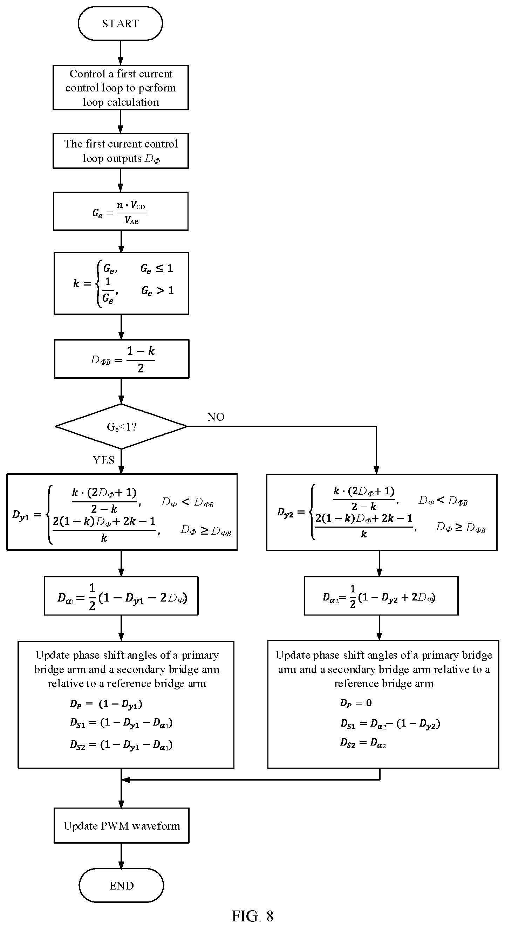

FIG. 8. The first current control loop outputs the phase shift angle $D_\Phi$ between the first voltage waveform $V_{AB}$ and the second voltage waveform $V_{CD}$, and variables required by a phase shift algorithm are calculated, where $k$ is an intermediate variable and determined by $G_e$, and $D_{\Phi B}$ is a boundary condition of $D_\Phi$. After the relevant variables are calculated, an equivalent duty cycle $D_{y1}$ of a primary bridge arm and an equivalent duty cycle $D_{y2}$ of a secondary bridge arm are calculated according to whether $G_e$ is greater than 1. Finally, phase shift angles of three bridge arms other than the reference bridge arm relative to the reference bridge arm are determined: $D_p$, $D_{s1}$, and $D_{s2}$.

Exemplarily, on condition that the reference bridge arm is the third bridge arm and the target bridge arm includes the second bridge arm, the fourth bridge arm, and the fifth bridge arm, a phase shift angle of the second bridge arm relative to the third bridge arm, a phase shift angle of the fourth bridge arm relative to the third bridge arm, and a phase shift angle of the fifth bridge arm relative to the third bridge arm are determined according to the following formulas:

when the demand gain of the energy conversion device is less than 1:

$$D_p=(1-D_{y1});\ D_{s1}=(1-D_{y1}-D_{\alpha1});\ D_{s2}=(1-D_{y1}-D_{\alpha1});$$

$$D_{\alpha1}=(1-D_{y1}+2D_\Phi)/2;$$

$$\text{if } D_\Phi < D_{\Phi B},\ D_{y1}=k\times(2D_\Phi+1)/(2-k);\ \text{if } D_\Phi \geq D_{\Phi B},\ D_{y1}=[2\times D_\Phi \times(1-k)+2k-1]/k;$$

$$D_{\Phi B}=(1-k)/2,\ k=G_e;$$

when the demand gain of the energy conversion device is greater than or equal to 1:

$$D_p=0;\ D_{s1}=D_{\alpha2}-(1-D_{y2});\ D_{s2}=D_{\alpha2};$$

$$D_{\alpha2}=(1-D_{y2}+2D_\Phi)/2;$$

$$\text{if } D_\Phi < D_{\Phi B},\ D_{y2}=k\times(2D_\Phi+1)/(2-k);\ \text{if } D_\Phi \geq D_{\Phi B},\ D_{y2}=[2\times D_\Phi \times(1-k)+2k-1]/k;$$

$$D_{\Phi B}=(1-k)/2,\ k=1/G_e;$$

where $G_e$ represents the demand gain of the energy conversion device, $D_\Phi$ represents the phase shift angle between the first voltage waveform and the second voltage waveform, $D_p$ represents the phase shift angle of the second bridge arm relative to the third bridge arm, $D_{s1}$ represents the phase shift angle of the fourth bridge arm relative to the third bridge arm, and $D_{s2}$ represents the phase shift angle of the fifth bridge arm relative to the third bridge arm.

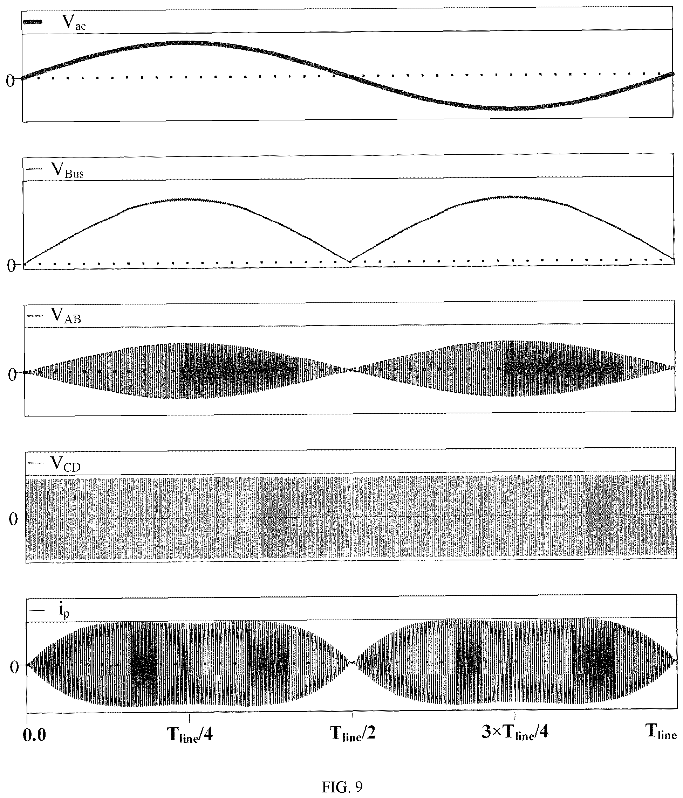

In order to explain the control strategy and control effect of embodiments of the disclosure in more detail, FIG. 9 illustrates waveforms of an inputted AC voltage $V_{ac}$, a voltage $V_{Bus}$ across the second filter capacitor $C_2$, the first voltage waveform $V_{AB}$, the second voltage waveform $V_{CD}$, and a primary current $i_p$ of the transformer Tr in one power frequency cycle ($T_{line}$ in FIG. 9). $V_{ac}$ is a voltage between the first AC end and the second AC end in FIG. 3 or FIG. 4 or FIG. 5 or FIG. 6, and $i_p$ is a current on the resonance inductor $L_r$ in FIG. 3 or FIG. 4 or FIG. 5 or FIG. 6. It can be seen from FIG. 9, the control strategy of embodiments of the disclosure can well realize power factor value and power transmission control. It is to be noted that, the power frequency cycle $T_{line}$ is greater than a switching cycle $T_s$.

FIG. 10 to FIG. 15 illustrate typical timing waveforms for switches with six different modulation methods in the case of $G_e<1$ (i.e., the energy conversion device operates in a buck mode) or $G_e>1$ (i.e., the energy conversion device operates in a boost mode) based on the control strategy of embodiments of the disclosure. By applying the control strategy, soft switching under different output voltages and different loads can be realized, thereby improving the efficiency of the energy conversion device. In FIG. 10 to FIG. 15, the horizontal axis is time, and the vertical axis is an amplitude of a waveform. A switch is turned off in a time period when a waveform of a drive signal for the switch has a vertical coordinate of 0; a switch is turned on in a time period when a waveform of a drive signal for the switch has a vertical coordinate greater than 0 (for example, when the vertical coordinate of a waveform of a drive signal for the fifth switch $S_5$ is 0, it indicates that the fifth switch $S_5$ is turned off; when the vertical coordinate of the waveform of the drive signal for the fifth switch $S_5$ is greater than 0, it indicates that the fifth switch $S_5$ is turned on). $G_e$ represents the demand gain of the energy conversion device, $D_\Phi$ represents the phase shift angle between the first voltage waveform and the second voltage waveform, $D_p$ represents the phase shift angle of the second bridge arm relative to the third bridge arm, $D_{s1}$ represents the phase shift angle of the fourth bridge arm relative to the third bridge arm, and $D_{s2}$ represents the phase shift angle of the fifth bridge arm relative to the third bridge arm. $V_{AB}$ represents the first voltage waveform, and $V_{CD}$ represents the second voltage waveform. $i_p$ represents a current on the resonance inductor $L_r$ in FIG. 3 or FIG. 4 or FIG. 5 or FIG. 6, and $T_s$ represents a switching cycle. $V_{ac}$ represents a value of a voltage between the first AC end and the second AC end in FIG. 3 or FIG. 4 or FIG. 5 or FIG. 6, and $V_{HV}$ represents a value of a voltage between the first DC end and the second DC end in FIG. 3.

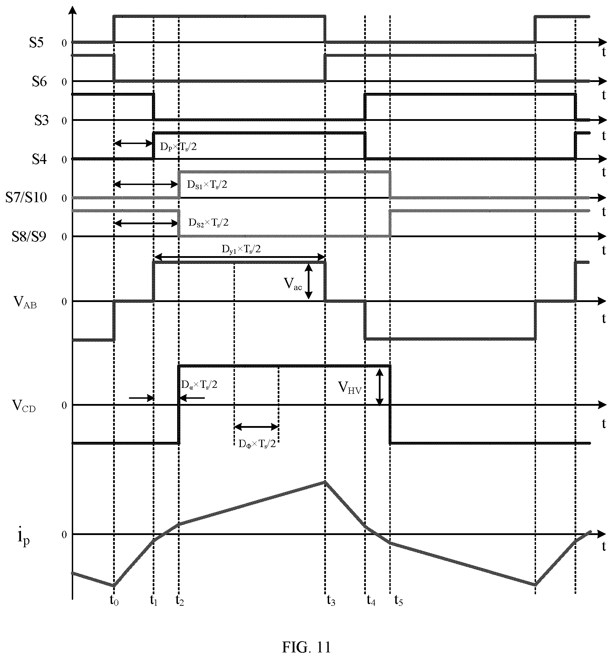

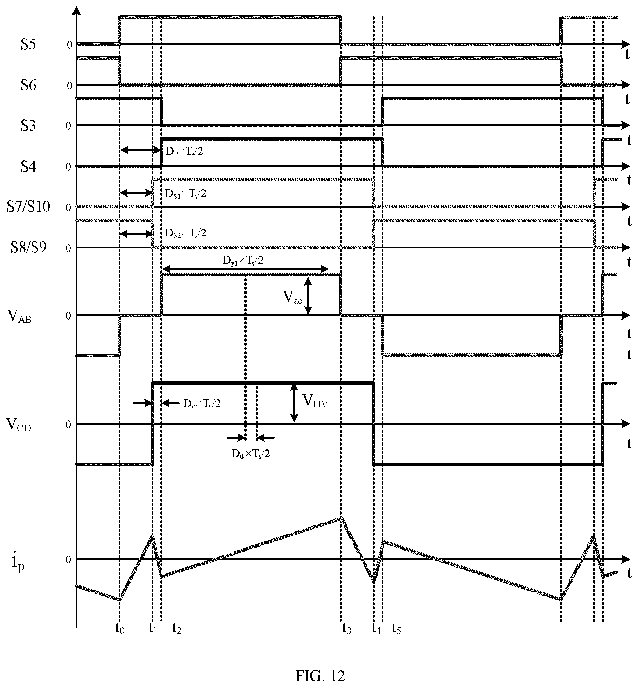

FIG. 10 to FIG. 12 illustrate three typical control waveforms when $G_e<1$. For convenience, dead time is ignored. The dotted line illustrated in the figures is at a switching moment. Taking the half switching cycle of the fifth switch $S_5$ as an example, it can be seen that, in a positive half cycle of the switching frequency of the fifth switch $S_5$, when $i_p$ is negative, a zero voltage switch (ZVS) corresponding to a primary switch is turned on; when $i_p$ is positive, a ZVS corresponding to a secondary switch is turned on. Conversely, in a negative half cycle of the switching frequency of the fifth switch $S_5$, when $i_p$ is negative, the ZVS corresponding to the secondary switch is turned on; when $i_p$ is positive, the ZVS corresponding to the primary switch is turned on. In FIG. 10, $G_e<1$, $D_P=0$, $D_{S1}=D_{S2}>0$. In FIG. 11, $G_e<1$, $0<D_P<D_{S1}=D_{S2}$. In FIG. 12, $G_e<1$, $D_P>D_{S1}=D_{S2}>0$.

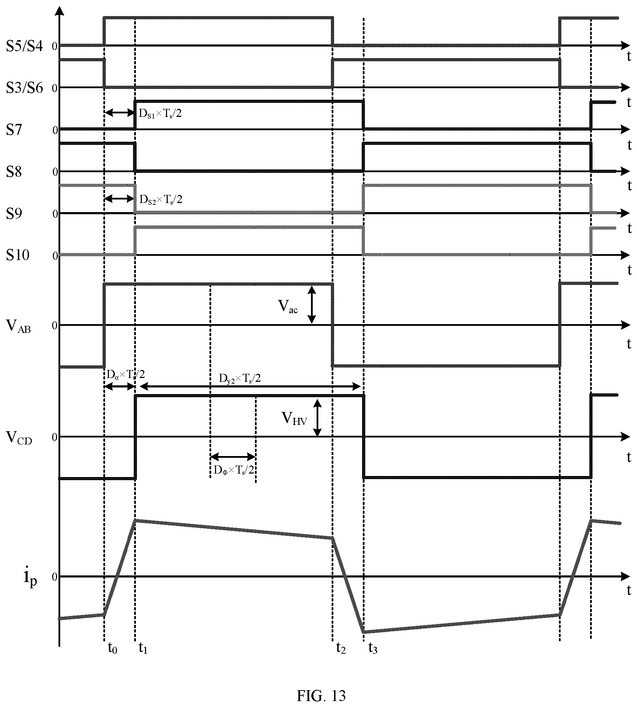

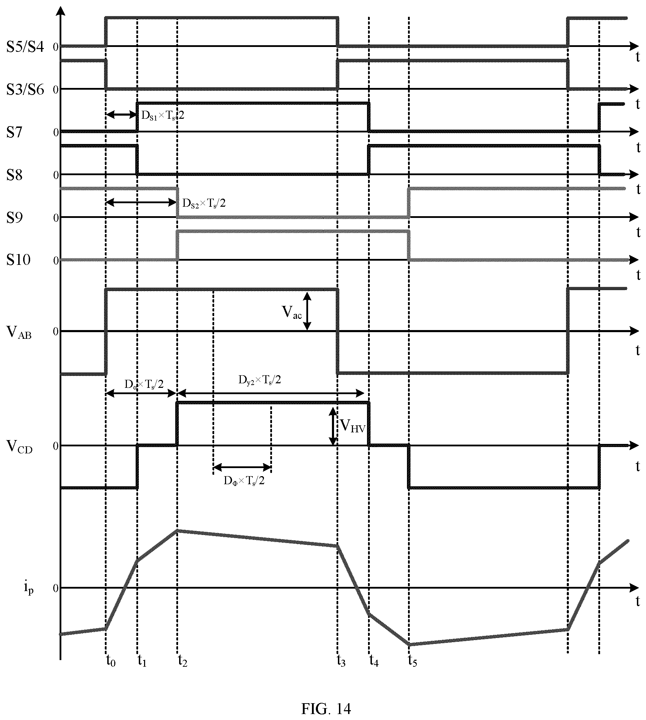

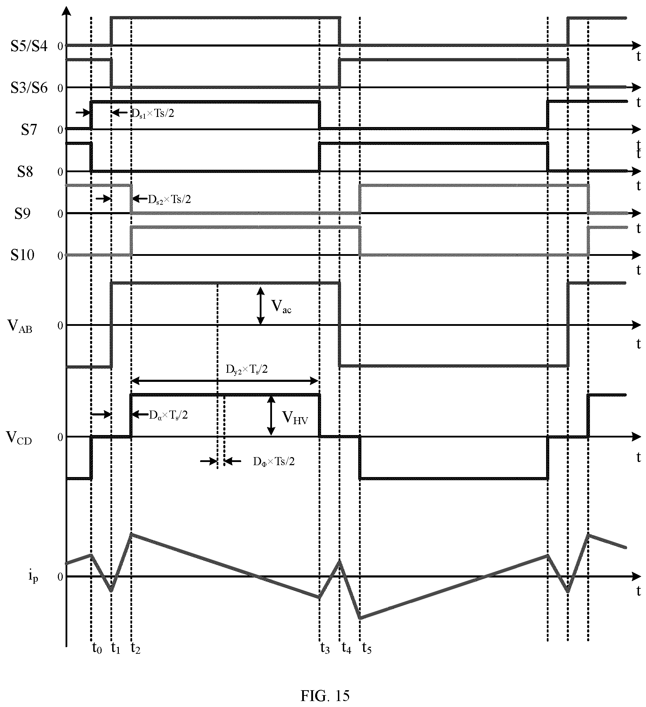

FIG. 13 to FIG. 15 illustrate three typical control waveforms when $G_e>1$. For convenience, dead time is ignored. The dotted line illustrated in the figures is at a switching moment. Taking the half switching cycle of the fifth switch $S_5$ as an example, it can be seen that, in a positive half cycle of the switching frequency of the fifth switch $S_5$, when $i_p$ is negative, the ZVS corresponding to the primary switch is turned on; when $i_p$ is positive, the ZVS corresponding to the secondary switch is turned on. Conversely, in a negative half cycle of the switching frequency of the fifth switch $S_5$, when $i_p$ is negative, the ZVS corresponding to the secondary switch is turned on; when $i_p$ is positive, the ZVS corresponding to the primary switch is turned on. In FIG. 13, $G_e>1$, $D_P=0$, $D_{S1}=D_{S2}>0$. In FIG. 14, $G_e>1$, $D_P=0$, $D_{S2}>$ Dsi$>0$. In FIG. 15, $G_e>1$, $D_P=0$, $D_{S1}<0$, $D_{S2}>0$.

It is to be noted that, in FIG. 10 to FIG. 15, $V_{AB}$ is the same as $V_{Bus\_FB}$ in FIG. 5 and FIG. 6, and $V_{CD}$ is the same as $V_{HV\_FB}$ in FIG. 3, FIG. 4, FIG. 5, and FIG. 6.

The primary switch herein refers to a switch(es) in the primary bridge arm module 20 (e.g., the third switch $S_3$, the fourth switch $S_4$, the fifth switch $S_5$, and the sixth switch $S_6$), and the secondary switch herein refers to a switch(es) in the secondary bridge arm module 40 (e.g., the seventh switch $S_7$, the eighth switch $S_8$, the ninth switch $S_9$, and the tenth switch $S_{10}$).

In embodiments of the disclosure, in order to realize PFC at the AC side, a modulation strategy is combined with a control strategy of a dual active bridge (DAB), the primary switch and the secondary switch of the transformer Tr each are modulated at a duty cycle of 50%, and the PFC and power transmission control are realized through the phase shift of the primary side and the secondary side, which has characteristics of simple control, easy implementation, and fast system response. In addition, in order to reduce the switching loss and improve the efficiency, the switching frequency $f_s$ should be designed to be higher than the resonant frequency. Also, a phase shift between primary bridge arms can be increased when $G_e<1$, and a phase shift between secondary bridge arms can be increased when $G_e>1$, which can further reduce the switching loss.

The topology of FIG. 3 or FIG. 4 or FIG. 5 or FIG. 6 is simple in structure and controllable in cost, and the energy conversion device has a prolonged lifespan, thereby saving user costs. The control strategy in FIG. 8 is relatively simple, and can be flexibly configured and driven through an algorithm to enable soft switching of a switch under conditions of different outputted voltages and different load, thereby improving an energy conversion efficiency of the energy conversion device and improving an electromagnetic interference (EMI) characteristic of the energy conversion device.

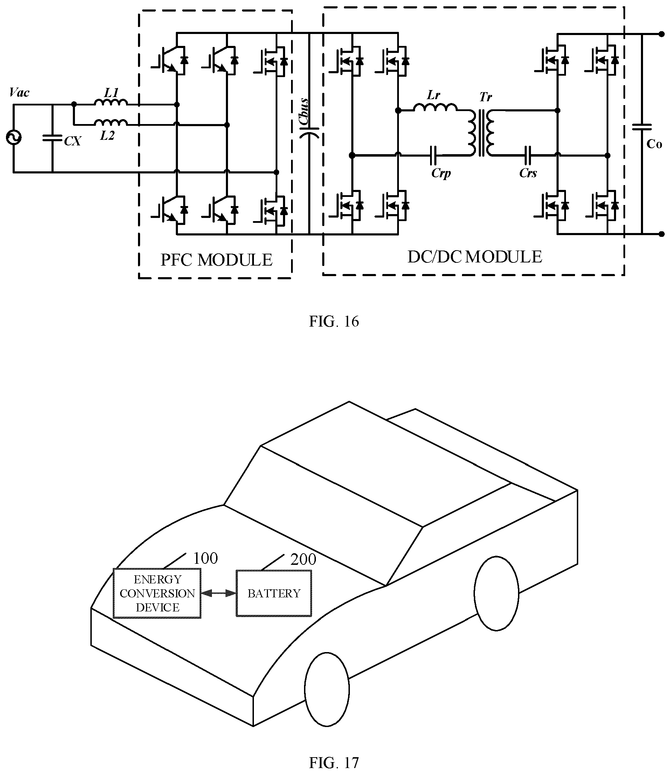

Referring to FIG. 16, FIG. 16 illustrates an energy conversion device with a PFC module and a DC/DC module provided in embodiments of the disclosure. FIG. 16 illustrates a traditional two-stage architecture topology, in which a relatively large electrolytic capacitor (e.g., *Cbus* in FIG. 16) needs to be provided between the PFC module and the DC/DC module. Compared to FIG. 16, FIG. 1 or FIG. 2 illustrates a single-stage topology. The single-stage topology in FIG. 1 or FIG. 2 not only does not require the electrolytic capacitor, but also feature a reduced total number of switches, which can further optimize the cost of the energy conversion device and improve reliability of the energy conversion device.

Referring to FIG. 17, FIG. 17 is a schematic structural diagram illustrating a vehicle provided in embodiments of the disclosure. As illustrated in FIG. 17, the vehicle includes an energy conversion device 100 and a battery 200. The battery 200 may be a power battery on the vehicle. The vehicle may be an electric vehicle. The energy conversion device 100 can be configured to convert an AC into a DC to charge the battery 200. The battery 200 can be configured to input the DC into the energy conversion device 100, and the energy conversion device 100 can be configured to convert the inputted DC into an AC for powering an AC load.

For details of the specific structure and the working principle of the energy conversion device 100 in FIG. 17, reference can be made to the foregoing embodiments illustrated in the FIG. 1 to FIG. 6, which will not be repeated herein.

In the foregoing embodiments, the description of each embodiment has its own emphasis. For a part not described in detail in one embodiment, reference may be made to related descriptions in other embodiments.

In the embodiments of the disclosure, it should be understood that, the energy conversion device and the vehicle disclosed herein may be implemented in other manners. For example, the above embodiments of the energy conversion device are merely illustrative; for instance, the division of the unit is only a logical function division and there can be other manners of division during actual implementations, for example, multiple units or assemblies may be combined or may be integrated into another system, or some features may be ignored, omitted, or not performed.

**Claims**

1. An energy conversion device, comprising a filter module, a primary bridge arm module, a resonance module, a secondary bridge arm module, and a control module; wherein the primary bridge arm module comprises a first bridge arm, a second bridge arm, and a third bridge arm, and the secondary bridge arm module comprises a fourth bridge arm and a fifth bridge arm; wherein a frequency of a drive signal for the second bridge arm, a frequency of a drive signal for the third bridge arm, a frequency of a drive signal for the fourth bridge arm, and a frequency of a drive signal for the fifth bridge arm each are higher than a frequency of a drive signal for the first bridge arm;

   wherein a first end of the filter module is connected with a first alternating current, AC, end, a second end of the filter module is connected with a bridge arm midpoint of the third bridge arm and a first end of the resonance module, a third end of the filter module is connected with a bridge arm midpoint of the second bridge arm and a second end of the resonance module, and a bridge arm midpoint of the first bridge arm is connected with a second AC end; a third end of the resonance module is connected with a bridge arm midpoint of the fourth bridge arm, and a fourth end of the resonance module is connected with a bridge arm midpoint of the fifth bridge arm; a first end of the first bridge arm is connected with a first end of the second bridge arm and a first end of the third bridge arm, a second end of the first bridge arm is connected with a second end of the second bridge arm and a second end of the third bridge arm, a first end of the fourth bridge arm is connected with a first end of the fifth bridge arm and a first direct current, DC, end, and a second end of the fourth bridge arm is connected with a second end of the fifth bridge arm and a second DC end;
   wherein the control module is configured to determine a phase shift angle of a target bridge arm relative to a reference bridge arm according to a demand gain of the energy conversion device, a first sampled current, a second sampled current, a first sampled voltage, and a second sampled voltage, to enable soft switching of switches in the primary bridge arm module and the secondary bridge arm module, wherein the reference bridge arm is one of the second bridge arm, the third bridge arm, the fourth bridge arm, and the fifth bridge arm, and the target bridge arm is a bridge arm other than the reference bridge arm among the second bridge arm, the third bridge arm, the fourth bridge arm, and the fifth bridge arm; the phase shift angle of the target bridge arm relative to the reference bridge arm is used for controlling a timing of a drive signal for the target bridge arm, the first sampled current is a sampled current at the first end of the filter module, the second sampled current is a sampled current between the second end of the fifth bridge arm and the second DC end, the first sampled voltage is a sampled voltage between the first AC end and the second AC end or a sampled voltage between the first end of the third bridge arm and the second end of the third bridge arm, and the second sampled voltage is a sampled voltage between the first DC end and the second DC end.

2. The energy conversion device of claim 1, wherein the resonance module comprises a resonance inductor, a first resonance capacitor, a second resonance capacitor, and a transformer; wherein the resonance inductor and the first resonance capacitor each are connected in series with a primary winding of the transformer, and the second resonance capacitor is connected in series with a secondary winding of the transformer.

3. The energy conversion device of claim 1, wherein the filter module comprises a first inductor and a second inductor; wherein a first end of the first inductor is connected with the first end of the second inductor and the first AC end, a second end of the first inductor is connected with the bridge arm midpoint of the third bridge arm, and a second end of the second inductor is connected with the bridge arm midpoint of the second bridge arm.

4. The energy conversion device of claim 1, wherein the filter module comprises a coupled inductor; wherein a first end of the coupled inductor is connected with a second end of the coupled inductor and the first AC end, a third end of the coupled inductor is connected with the bridge arm midpoint of the third bridge arm, and a fourth end of the coupled inductor is connected with the bridge arm midpoint of the second bridge arm.

5. The energy conversion device of any of claims 1 to 4, wherein the energy conversion device further comprises a first filter capacitor, a second filter capacitor, and a third filter capacitor; wherein two ends of the first filter capacitor are respectively connected with the first AC end and the second AC end, two ends of the second filter capacitor are respectively connected with the first end of the third bridge arm and the second end of the third bridge arm, and two ends of the third filter capacitor are respectively connected with the first end of the fifth bridge arm and the second end of the fifth bridge arm.

6. The energy conversion device of claim 2, wherein the control module configured to determine the phase shift angle of the target bridge arm relative to the reference bridge arm according to the demand gain of the energy conversion device, the first sampled current, the second sampled current, the first sampled voltage, and the second sampled voltage is configured to:

determine a phase shift angle between a first voltage waveform and a second voltage waveform according to the first sampled current, the second sampled current, the first sampled voltage, and the second sampled voltage, wherein the first voltage waveform is a waveform of a voltage between the bridge arm midpoint of the third bridge arm and the bridge arm midpoint of the second bridge arm, and the second voltage waveform is a waveform of a voltage between the bridge arm midpoint of the fourth bridge arm and the bridge arm midpoint of the fifth bridge arm; and

determine the phase shift angle of the target bridge arm relative to the reference bridge arm according to the phase shift angle between the first voltage waveform and the second voltage waveform, the demand gain of the energy conversion device, a turns ratio of the transformer, the first sampled voltage, and the second sampled voltage.

7. The energy conversion device of claim 6, wherein the control module comprises a phase-locked loop, a first current control loop, a second current control loop, a voltage control loop, a multiplier, a minimum selection module, and a phase-shift modulation module, wherein

the phase-locked loop is configured to output a first loop calculation result by performing loop calculation on the first sampled voltage;
the second current control loop is configured to output a second loop calculation result by performing loop calculation on a result of a subtraction operation between the second sampled current and a first reference current;
the voltage control loop is configured to output a third loop calculation result by performing loop calculation on a result of a subtraction operation between the second sampled voltage and a second reference voltage;
the minimum selection module is configured to select a minimum value from the second loop calculation result and the third loop calculation result;
the multiplier is configured to obtain a second reference current by multiplying the first loop calculation result with the minimum value selected from the second loop calculation result and the third loop calculation result;
the first current control loop is configured to output the phase shift angle between the first voltage waveform and the second voltage waveform by performing loop calculation on a result of a subtraction operation between the first sampled current and the second reference current; and

the phase-shift modulation module is configured to determine the phase shift angle of the target bridge arm relative to the reference bridge arm according to the phase shift angle between the first voltage waveform and the second voltage waveform, the demand gain of the energy conversion device, the turns ratio of the transformer, the first sampled voltage, and the second sampled voltage.

8. The energy conversion device of claim 6 or 7, wherein in response to the reference bridge arm being the third bridge arm and the target bridge arm comprising the second bridge arm, the fourth bridge arm, and the fifth bridge arm, when the demand gain of the energy conversion device is less than 1, a phase shift angle of the second bridge arm relative to the third bridge arm, a phase shift angle of the fourth bridge arm relative to the third bridge arm, and a phase shift angle of the fifth bridge arm relative to the third bridge arm are determined according to the following formulas:

$$D_p=(1-D_{y1});\ D_{s1}=(1-D_{y1}-D_{\alpha1});\ D_{s2}=(1-D_{y1}-D_{\alpha1});\ D_{\alpha1}=(1-D_{y1}+2D_\Phi)/2;$$

$$\text{if } D_\Phi < D_{\Phi B},\ D_{y1}=k\times(2D_\Phi+1)/(2-k);$$

$$\text{if } D_\Phi \geq D_{\Phi B},\ D_{y1}=[2\times D_\Phi\times(1-k)+2k-1]/k;$$

$$D_{\Phi B}=(1-k)/2,\ k=G_e;$$

wherein $G_e$ represents the demand gain of the energy conversion device, $D_\Phi$ represents the phase shift angle between the first voltage waveform and the second voltage waveform, $D_p$ represents the phase shift angle of the second bridge arm relative to the third bridge arm, $D_{s1}$ represents the phase shift angle of the fourth bridge arm relative to the third bridge arm, and $D_{s2}$ represents the phase shift angle of the fifth bridge arm relative to the third bridge arm.

9. The energy conversion device of claim 8, wherein when the demand gain of the energy conversion device is greater than or equal to 1:

$$D_p=0;\ D_{s1}=D_{\alpha2}-(1-D_{y2});\ D_{s2}=D_{\alpha2};\ D_{\alpha2}=(1-D_{y2}+2D_\Phi)/2;$$

$$\text{if } D_\Phi < D_{\Phi B},\ D_{y2}=k\times(2D_\Phi+1)/(2-k);$$

$$\text{if } D_\Phi \geq D_{\Phi B},\ D_{y2}=[2\times D_\Phi\times(1-k)+2k-1]/k;$$

$$D_{\Phi B}=(1-k)/2,\ k=1/G_e;$$

wherein $G_e$ represents the demand gain of the energy conversion device, $D_\Phi$ represents the phase shift angle between the first voltage waveform and the second voltage waveform, $D_p$ represents the phase shift angle of the second bridge arm relative to the third bridge arm, $D_{s1}$ represents the phase shift angle of the fourth bridge arm relative to the third bridge arm, and $D_{s2}$ represents the phase shift angle of the fifth bridge arm relative to the third bridge arm.

10. A vehicle, comprising the energy conversion device of any of claims 1 to 9 and a battery, the energy conversion device being configured to convert an AC into a DC to charge the battery.

FIG. 1

FIG. 2

FIG. 3

FIG. 4

FIG. 5

FIG. 6

Determining, by a control module, a phase shift angle between a first voltage waveform and a second voltage waveform according to a first sampled current, a second sampled current, a first sampled voltage, and a second sampled voltage, where the first voltage waveform is a waveform of a voltage between a bridge arm midpoint of a third bridge arm and a bridge arm midpoint of a second bridge arm, and the second voltage waveform is a waveform of a voltage between a bridge arm midpoint of the fourth bridge arm and a bridge arm midpoint of the fifth bridge arm — 701

Determining, by the control module, a phase shift angle of a target bridge arm relative to a reference bridge arm according to the phase shift angle between the first voltage waveform and the second voltage waveform, a demand gain of an energy conversion device, a turns ratio of a transformer, the first sampled voltage, and the second sampled voltage — 702

FIG. 7

START

Control a first current
control loop to perform
loop calculation

The first current control
loop outputs $D_\Phi$

$$G_e = \frac{n \cdot V_{CD}}{V_{AB}}$$

$$k = \begin{cases} G_e, & G_e \leq 1 \\ \dfrac{1}{G_e}, & G_e > 1 \end{cases}$$

$$D_{\Phi B} = \frac{1 - k}{2}$$

$G_e < 1$?

NO

YES

$$D_{y1} = \begin{cases} \dfrac{k \cdot (2D_\Phi + 1)}{2 - k}, & D_\Phi < D_{\Phi B} \\ \dfrac{2(1-k)D_\Phi + 2k - 1}{k}, & D_\Phi \geq D_{\Phi B} \end{cases}$$

$$D_{y2} = \begin{cases} \dfrac{k \cdot (2D_\Phi + 1)}{2 - k}, & D_\Phi < D_{\Phi B} \\ \dfrac{2(1-k)D_\Phi + 2k - 1}{k}, & D_\Phi \geq D_{\Phi B} \end{cases}$$

$$D_{\alpha 1} = \frac{1}{2}(1 - D_{y1} - 2D_\Phi)$$

$$D_{\alpha 2} = \frac{1}{2}(1 - D_{y2} + 2D_\Phi)$$

Update phase shift angles of a primary
bridge arm and a secondary bridge arm
relative to a reference bridge arm

$$D_P = (1 - D_{y1})$$
$$D_{S1} = (1 - D_{y1} - D_{\alpha 1})$$
$$D_{S2} = (1 - D_{y1} - D_{\alpha 1})$$

Update phase shift angles of a primary bridge
arm and a secondary bridge arm relative to a
reference bridge arm

$$D_P = 0$$
$$D_{S1} = D_{\alpha 2} - (1 - D_{y2})$$
$$D_{S2} = D_{\alpha 2}$$

Update PWM waveform

END

FIG. 8

FIG. 9

FIG. 10

FIG. 11

FIG. 12

FIG. 13

FIG. 14

FIG. 15

FIG. 16

FIG. 17

TRANSLATION

## INTERNATIONAL SEARCH REPORT

| International application No. |
|---|
| **PCT/CN2024/138673** |

| A. | CLASSIFICATION OF SUBJECT MATTER |
|---|---|

H02M7/219(2006.01)i; H02M3/335(2006.01)i; H02M1/00(2007.01)i

According to International Patent Classification (IPC) or to both national classification and IPC

| B. | FIELDS SEARCHED |
|---|---|

Minimum documentation searched (classification system followed by classification symbols)

IPC: H02M

Documentation searched other than minimum documentation to the extent that such documents are included in the fields searched

Electronic data base consulted during the international search (name of data base and, where practicable, search terms used)

CNTXT, ENTXTC, DWPI, VEN, CNKI, IEEE: 谐振, 并联, 三, 桥臂, 隔离, 变压器, 移相, 相移, resonant, parallel, three, arm, isolation, transformer, phase shift

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 119010614 A (SHINRY TECHNOLOGIES CO., LTD.) 22 November 2024 (2024-11-22) claims 1-10 | 1-10 |
| A | CN 104022675 A (YANSHAN UNIVERSITY) 03 September 2014 (2014-09-03) description, paragraphs [0036]-[0041] and [0053]-[0054], and figures 1 and 4-5 | 1-10 |
| A | CN 113765358 A (SHENZHEN VMAX NEW ENERGY CO., LTD.) 07 December 2021 (2021-12-07) figure 1 | 1-10 |
| A | CN 221042676 U (SUZHOU INOVANCE AUTOMOTIVE CO., LTD.) 28 May 2024 (2024-05-28) entire document | 1-10 |
| A | US 2022416673 A1 (GUOCHUANG INNOVATION CENTER OF MOBILE ENERGY (JIANGSU) CO., LTD.) 29 December 2022 (2022-12-29) entire document | 1-10 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **11 July 2025** | **17 July 2025** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

TRANSLATION

**INTERNATIONAL SEARCH REPORT**
Information on patent family members

International application No.

**PCT/CN2024/138673**

| Patent document cited in search report | | | Publication date (day/month/year) | Patent family member(s) | | | Publication date (day/month/year) |
|---|---|---|---|---|---|---|---|
| CN | 119010614 | A | 22 November 2024 | None | | | |
| CN | 104022675 | A | 03 September 2014 | None | | | |
| CN | 113765358 | A | 07 December 2021 | None | | | |
| CN | 221042676 | U | 28 May 2024 | None | | | |
| US | 2022416673 | A1 | 29 December 2022 | US | 11728749 | B2 | 15 August 2023 |
| | | | | EP | 4109731 | A1 | 28 December 2022 |
| | | | | EP | 4109731 | B1 | 20 December 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202411475163